(19) Europäisches Patentamt
European Patent Office
Office européen des brevets

(11) **EP 4 712 126 A1**

(12) **EUROPEAN PATENT APPLICATION**

(43) Date of publication:
**18.03.2026 Bulletin 2026/12**

(21) Application number: **25200745.5**

(22) Date of filing: **08.09.2025**

(51) International Patent Classification (IPC):
**H01J 37/26** (2006.01)

(52) Cooperative Patent Classification (CPC):
**H01J 37/265; H01J 2237/24485; H01J 2237/24585;
H01J 2237/2516; H01J 2237/2802; H01J 2237/2826**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **06.09.2024 US 202418827589**

(71) Applicant: **FEI COMPANY
Hillsboro, OR 97124 (US)**

(72) Inventors:
• **SHÁNEL, Ondrej
Brno (CZ)**
• **TIEMEIJER, Peter Christiaan
Eindhoven (NL)**
• **LAZAR, Sorin
Eindhoven (NL)**

(74) Representative: **Boult Wade Tennant LLP
Salisbury Square House
8 Salisbury Square
London EC4Y 8AP (GB)**

(54) **TECHNIQUES FOR ELECTRON ENERGY LOSS SPECTROSCOPY AT HIGH ENERGY LOSSES WITH MAGNETIC IMMERSION OBJECTIVE**

(57) Systems, devices, methods, algorithms, and techniques for energy-loss spectroscopy at relatively large energy losses are described. A method includes modifying an accelerating voltage of a source of the system from a first energy to a second energy. The method can include modifying one or more optical elements of the system, in accordance with a calibration for the second energy. The method can include generating a set of operating conditions for a projection optics system. The method can include modifying one or more elements of the projection optics system in at least partial accordance with the set of operating conditions. The method can include modifying a condenser lens of the system in accordance with focusing a beam of charged particles onto a sample position. The method can also include modifying the accelerating voltage from the second energy to the first energy.

FIG. 2

EP 4 712 126 A1

## Description

TECHNICAL FIELD

Embodiments of the present disclosure are directed to charged particle beam systems, as well as algorithms and methods for their operation. In particular, some embodiments are directed toward techniques for electron energy loss spectroscopy.

BACKGROUND

Electron energy loss spectroscopy (EELS) describes techniques whereby information about the electronic structure of a material sample can be derived by passing a beam of electrons through the sample, scattering a portion of the electrons. EELS spectrometers operate by collecting inelastically scattered electrons downstream of the sample, relative to the position of a source of electrons, and dispersing these electrons spatially by the energy lost in the inelastic scattering. The spatially dispersed electrons impinge on a detector that generates EELS spectrum data. Challenges with EELS include that the inelastically scattered electrons are increasingly out of focus with increasing energy loss, and that the scattering cross section rapidly decreases with increasing energy loss, leading to signal-to-noise limitations for excitations above about 2 keV.

In contrast to other techniques that offer similar spectral data, such as synchrotrons, EELS spectrometers configured to operate as part of charged particle beam systems are typically calibrated for a single energy of a beam of electrons, namely the energy of the primary beam of the charged particle microscope. As such, EELS spectrometers are constrained to a relatively narrow energy range about a "zero loss peak" or ZLP that corresponds to the primary beam energy. Inelastic collisions that include energy transfers greater than about 1% of the primary beam energy (e.g., greater than about 2 keV for a 200keV primary beam), such as inner-shell ionizations and other relatively high energy interactions between the beam of electrons and the sample, suffer from poor signal-to-noise and aberration artifacts, and are generally considered outside the range of quality data for typical EELS spectrometers. Synchrotron systems are typically used to generate such data, using beam lines for tender X-rays or hard X-rays, at significantly lower spatial resolution, higher complexity, and expense. There is a need, therefore, for techniques and systems for probing inner-shell and other relatively high energy transitions of a material sample using EELS systems in a charged particle microscope.

SUMMARY

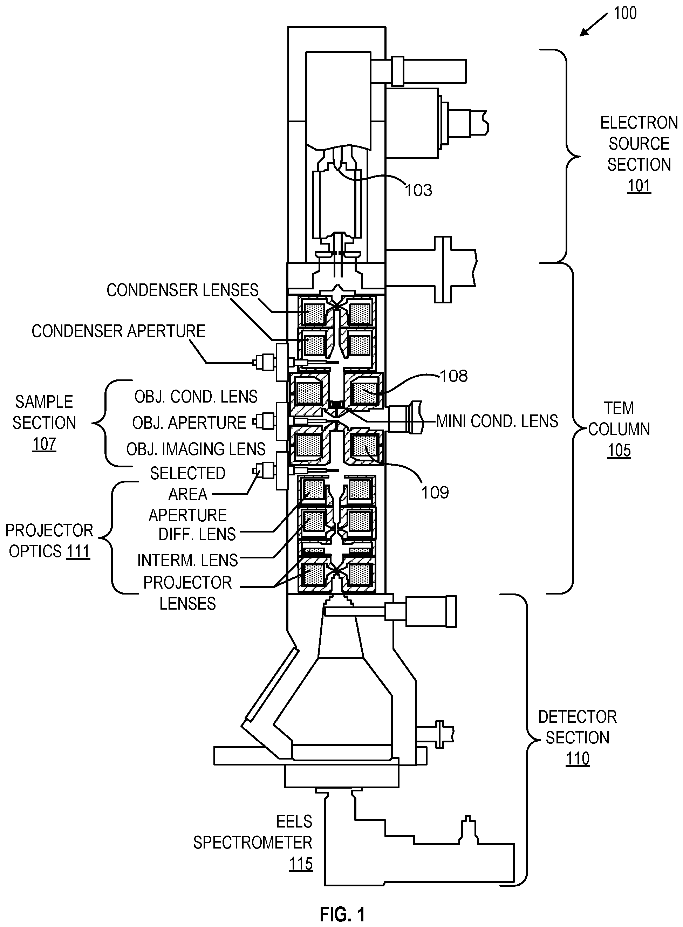

Systems, devices, methods, algorithms, and techniques for energy-loss spectroscopy at relatively large energy losses are described. In a first aspect, a method for interrogating a sample with a charged particle beam system, as described in reference to FIGs. 1-6, includes modifying an accelerating voltage of a source of the charged particle beam system from a first energy to a second energy. The first energy and the second energy can be separated by an energy difference. The method can include modifying one or more optical elements of the charged particle beam system, such that the optical element(s) is/are calibrated for the second energy. The method can include generating a set of operating conditions for a projection optics system of the charged particle beam system. The set of operating conditions can be based at least in part on operating the source at about the second energy. The method can include modifying one or more elements of the projection optics system in at least partial accordance with the set of operating conditions. The method can include modifying a condenser lens of the charged particle beam system in accordance with focusing a beam of charged particles onto a sample position. The beam of charged particles can have an energy about the second energy. The method can also include modifying the accelerating voltage from the second energy to the first energy.

In some embodiments, the method further includes modifying one or more optical elements of an electron energy loss (EELS) spectrometer of the charged particle beam system in accordance with focusing the beam of charged particles onto a detector of the EELS spectrometer. The beam of charged particles can have an energy about the second energy. The beam of charged particles can be a first beam, The method can further include generating a second beam of charged particles. The second beam of charged particles can have an energy about the first energy. The method can further include directing the first beam of charged particles through the sample position. The method can also further include generating detector data using the detector of the EELS spectrometer.

In some embodiments, the method further includes modifying one or more optical elements of the charged particle beam system in accordance with focusing the beam of charged particles onto the sample position. The focusing can correspond to a fine focus at a spatial resolution of about 0.1 nm or less. The second energy can be from about 90% to about 98.5% of the first energy. The first energy can be about 300 keV and the second energy can be from about 270 keV to about 295 keV. The first energy and the second energy can be related by the expression $A = |(\Delta E + E2 - E1)/E2|$, where $\Delta E$ is the energy loss associated with an edge (keV), E1 is the first energy (keV), and E2 is the second energy (keV); and the expression A is from about 1 % to about 10%.

In some embodiments, generating the set of operating conditions includes determining a solution for a first order approximation of the projection optics assembly. The solution can configure the beam of charged particles to define a final cross over (FXO) between the projection optics assembly and a detector plane that substantially satisfies one or more boundary conditions of the charged particle beam system. The boundary conditions can include a magnification at a detector of the charged particle beam system. Determining the solution can include referencing a dataset of operating conditions for the charged particle beam system using the second energy and an input parameter. The dataset can describe multiple sets of operating conditions for the projection optics assembly associated with one or more accelerating voltages. Determining the solution can include solving a mathematical expression describing the first order approximation of the projection optics assembly.

In a second aspect, a system can include a charged particle beam source, a charged particle optical column coupled with the source, and a detector section, as described in more detail in reference to FIGs. 1-6. The column can be configured to receive a beam of charged particles from the source. The column can include an objective section. The objective section can include a magnetic immersion objective and can define a sample position. The magnetic immersion objective can include a probe forming objective lens and an imaging objective lens. The sample position can be defined between the probe forming objective lens and the imaging objective lens, with respect to a beam axis, A, of the system. The column can further include a projection optics assembly. The projection optics assembly can include one or more projection optics. The system can further include a detector section, coupled with the column. The detector section can include an energy loss spectrometer, configured to receive a beam of charged particles via the projection optics assembly. The spectrometer can include a detector configured to generate detector data in response to interaction(s) of charged particle(s) of the beam of charged particles with the detector.

The system can also include control circuitry, operably coupled with the source, the column, and the detector section. The control circuitry can be operably coupled with one or more machine readable storage media, storing instructions that, when executed by a machine, cause the system to perform one or more operations of the method of the first aspect in one or more embodiments.

In a third aspect, one or more machine readable storage media store instructions that, when executed by a machine, cause the machine to perform one or more operations of the method of the first aspect in one or more embodiments. In some embodiments, the media of the third aspect can be operably coupled with the system of the second aspect. The media can be operably coupled with the control circuitry of the system of the second aspect.

Embodiments of the present disclosure also include systems, components, and methods in accordance with the preceding aspects. The terms and expressions which have been employed are used as terms of description and not of limitation, and there is no intention in the use of such terms and expressions of excluding any equivalents of the features shown and described or portions thereof, but it is recognized that various modifications are possible within the scope of the claimed subject matter. Thus, it should be understood that although the present claimed subject matter has been specifically disclosed by embodiments and optional features, modification and variation of the concepts herein disclosed can be resorted to by those skilled in the art, and that such modifications and variations are considered to be within the scope of this disclosure as defined by the appended claims.

DESCRIPTION OF THE DRAWINGS

The foregoing aspects and many of the attendant advantages of the present disclosure will become more readily appreciated as the same become better understood by reference to the following detailed description, when taken in conjunction with the accompanying drawings.

FIG. 1 is a schematic diagram illustrating an example charged particle beam system, in accordance with some embodiments of the present disclosure.

FIG. 2 is a schematic diagram illustrating principles of operation of the example charged particle beam system of FIG. 1, in accordance with some embodiments of the present disclosure.

FIG. 3 is a block diagram illustrating an example process 300 for interrogating a sample with a charged particle beam system, in accordance with some embodiments of the present disclosure.

FIGs. 4A-4D are schematic diagrams illustrating charged particle optical elements of a charged particle beam system, in accordance with the current art.

FIG. 4E is a schematic diagrams illustrating charged particle optical elements of a charged particle beam system, in accordance with some embodiments of the present disclosure.

FIG. 5A is a graph illustrating example electron energy loss spectrum (EELS) data for a copper foil sample, in accordance with some embodiments of the present disclosure.

FIG. 5B is a graph illustrating a detail of the example electron energy loss spectrum (EELS) data for the copper sample of FIG. 5A in comparison with EXAFS data, in accordance with some embodiments of the present disclosure.

FIG. 6 shows various parameters that can be used to describe first-order particle-optical effects of a thick magnetic lens, in accordance with some embodiments of the present disclosure.

In the drawings, like reference numerals refer to like parts throughout the various views unless otherwise specified. Not all instances of an element are necessarily labeled to reduce clutter in the drawings where appropriate. The drawings are not necessarily to scale, emphasis instead being placed upon illustrating the principles being described.

DETAILED DESCRIPTION

While embodiments have been illustrated and described, it will be appreciated that various changes can be made therein without departing from the spirit and scope of the disclosure. In the forthcoming paragraphs, embodiments of a charged particle beam system, components, and methods for electron energy loss spectroscopy (EELS) are described. Embodiments of the present disclosure focus on sample microanalysis using EELS-equipped transmission electron microscope (TEM) systems in the interest of simplicity of description. Embodiments are not limited to such systems, but rather are contemplated for systems where analysis of inelastic collisions between a beam of charged particles and atoms of a sample can be complicated by the internal configuration of charged particle optical components. In an illustrative example, scanning electron microscope (SEM) systems can be used for EELS analysis in scanning-transmission (STEM-in-SEM) modes. Similarly, systems can be configured specifically for EELS techniques, omitting typical components of TEM systems adapted for imaging, x-ray microanalysis, or the like. As such, while embodiments of the present disclosure focus on TEM platforms equipped with systems for generating and processing EELS data, additional and/or alternative systems and approaches are contemplated.

Embodiments of the present disclosure include systems, methods, algorithms, and non-transitory media storing computer-readable instructions for electron energy loss spectroscopy (EELS) at relatively high energy losses. In an illustrative example, a charged particle beam system can include a beam column section including one or more charged particle optical elements calibrated for a first energy and one or more charged particle optical elements calibrated for a second energy. In systems configured to immerse a sample in an objective field, so-called magnetic immersion objective lenses, embodiments of the present disclosure include generating a set of operating conditions for a projection optics assembly that resolves shifts in one or more beam crossovers, allowing an assembly of objective optics to remain calibrated to the energy of the charged particle source, while optics disposed downstream of the sample to be (re) calibrated for a second energy, corresponding to a relatively large inelastic transition (e.g., 2 keV or greater). Advantageously, embodiments of the present disclosure improve performance of energy loss spectrometry systems when measuring relatively large energy losses when operating with an objective field immersing the sample, thereby reducing reliance on synchrotron systems for generating comparable data.

In comparison to charged particle microscopes, synchrotron systems are complex, large, and not scalable. Techniques presented herein permit charged particle beam systems to generate detector data comparable to extended x-ray absorption fine-structure (EXAFS) spectra using existing EELS detector systems. As an additional advantage, EELS in scanning transmission electron microscopes (STEM) generally provides significantly improved spatial resolution (e.g., on the order of $10^3$-fold better spatial resolution). Improvements to spatial resolution at such scales significantly increases the depth of information available from nanostructured samples that can vary chemically and structurally over length scales that would be typically be integrated by synchrotron analysis on $\mu$m to mm scales.

The following detailed description focuses on embodiments of transmission electron microscope systems, but it is contemplated that additional and/or alternative instrument systems can be improved through the use of the techniques described. Instrument systems can include other charged particle systems including, but not limited to, focused ion-beam systems, scanning electron microscope systems, ion-electron dual-beam systems, or the like.

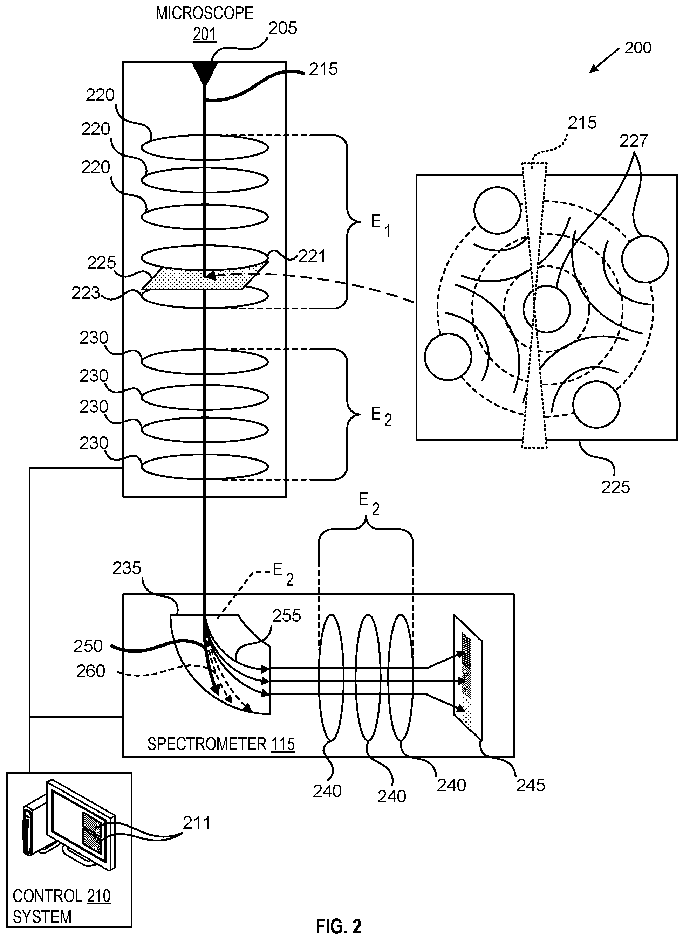

FIG. 1 is a schematic diagram illustrating an example charge particle microscope system 100, in accordance with some embodiments of the present disclosure. In the following description, details of internal components and functions of the example TEM system 100 are omitted for simplicity and to focus description on embodiments of the present disclosure, as described in more detail in reference to FIGs. 2-5, and on techniques for augmenting sample information in spectra including relatively strong background information. The example TEM system 100 includes an electron source section 101, a TEM column 105 including an sample section 107, an objective probe-forming lens 108, an objective imaging lens 109, a projection optics system 111, and a detector section 110. The present disclosure focuses on techniques for improving the performance of the detector section 110, with attention paid to embodiments of the present disclosure that include one or more electron energy loss spectroscopy (EELS) spectrometers 115.

In brief, the electron source section includes electronics configured to energize a source of charged particles 205 (in reference to FIG. 2), which can include a high-voltage field-emission source or other sources of emitted electrons, such that a beam of electrons is formed and conducted through a vacuum into the TEM column 105. The TEM column 105 includes components for beam forming, including electromagnetic lenses and/or electrostatic lenses, and multiple apertures to control properties of the beam of electrons. The TEM column 105 components include condenser lenses, objective lenses, projector lenses, aberration correctors, deflectors, stigmators, among others, as well as corresponding apertures. The sample section 107 hosts a sample 225 (in reference to FIG. 2) through which the beam of electrons can be transmitted. In the case of EELS microanalysis, the beam can be focused onto the sample for spot mode analysis (e.g., through the action of the probe-forming objective lens 108) or the beam can be passed through the sample in parallel illumination mode (or at least partially defocused) to gather data from a relatively large sample area (e.g., through the action of the objective imaging lens 109).

In some embodiments, the sample section 107 includes a probe-forming objective lens 108 and an imaging objective lens 109 that share the same magnetic lens field, also termed an objective field of the objective lens as to immerse the sample in this magnetic field. Advantageously, disposing the sample in the objective field of the objective lens can provide a resolution for STEM mode operation as good as about 0.05 nm. In this context, immersion in the objective field refers to disposing the sample in the magnetic field of the objective lens that extends into the space between the sample and a pole piece of the objective lens. Such immersion significantly reduces possible aberrations of the objective lens, which otherwise would reduce the spatial resolution of the microscope. As described in more detail in reference to the forthcoming figures, configuring the objective lenses 108 and 109 to generate the immersion objective field can constrain the operation of the example system 100 to provide a consistent calibration of the objective optics across the sample position. For example, the magnetic lens field shared by the objective lenses 108 and 109 in the immersion objective lens system can constrain the calibration (e.g., the operating energy) of the objective lens 109 to be dependent on the calibration (e.g., the operating energy) of the objective lens 108. In traditional methods, such constraint severely restricts the proper transfer of inelatically scattered electrons to the EELS detector. To that end, embodiments of the present disclosure enable EELS techniques at relatively large energy losses, while operating with an objective field at the sample position.

In some embodiments, the charged particle beam system 100 operates in field-free STEM mode, where the objective lens is not used to focus charged particles onto the sample. In some systems, a mini-condenser lens upstream of the specimen can act as probe-forming lens and a Lorentz lens downstream of the specimen can act as a first imaging lens to provide at least some of the functions of the objective lens. In field-free STEM mode, detector data can be generated at a spatial resolution of about 0.5 nm. While an order of magnitude worse than the immersion case, field-free STEM mode still offers significantly improved spatial resolution when compared to synchrotron-based techniques.

A state-of-the-art TEM column can have as many as four condenser lenses for flexible (e.g., step-wise or graduated) demagnification and concentration of the electron beam on the sample, and as many as five projector lenses for flexible magnification of the electron beam downstream of the sample to the detectors, and as many as two aberration correctors. Since a state-of-the-art aberration corrector can comprise additional lenses and several multipoles (e.g., four lenses and two-three or more multipoles), a modern TEM column can include up to about twenty lenses. Coordinated operation of the ensemble of lenses and other optical elements results in a given demagnification at the sample and magnification at the detector. A lack of coordination, in contrast, results in aberrations based at least in part on the electron beam travelling out-of-center through one or more optical elements, the beam having too large beam diameter in one or more lenses, or other issues that reduce system performance. In the context of the present disclosure, "calibration" and "recalibration" of charged particle optical elements refers to a set of operating parameters for an ensemble of elements for which excitation parameters are set and verified to give the desired beam properties at the sample (e.g., probe diameter, current, position) and the desired beam properties at the detector (e.g., magnification, focus, position). As would be understood by a person of ordinary skill in the relevant art, (re)calibration of the ensemble of optical elements is typically a complex and laborious task that can occupy several days or weeks of work by an experienced engineer. For this reason, TEM columns are typically supplied with calibration settings for a limited number (e.g., two to five) energies of the electron beam (e.g., 300 keV, 200 keV, 60 keV), making arbitrary changes to the calibration of the optics practically unavailable in most conventional TEM systems.

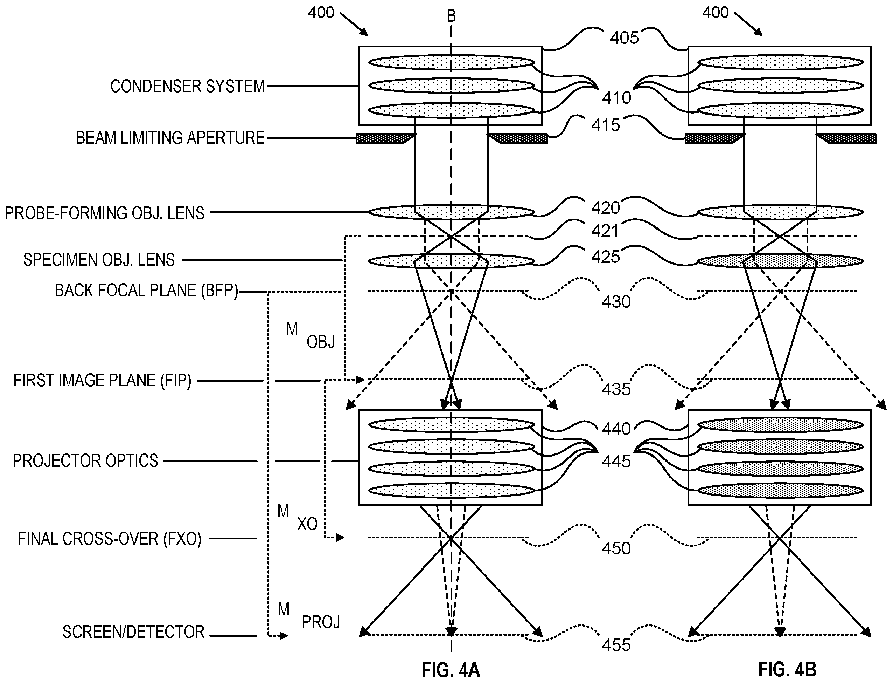

The optical strengths of lenses and multipoles depend on the energy of the electron in the beam and therefore a calibration is specific to electrons with energy equal to or close to the energy for which the calibration settings have been set and verified. For example, in a TEM that is operating with a beam energy of 300 keV, charged particle optical elements of the TEM column that are calibrated for the beam at 300 keV will introduce minimal aberrations (such as defocus, coma, shift, etc.) into the beam. In this example, however, an electron having an energy that deviates from 300 keV by as little as 10eV, a deviation of about 0.003%, will be focused onto a plane that is shifted away from the intended sample plane by a distance of about 100 nm. The chromatic aberration of the objective lens, in this example, significantly impairs the spatial resolution of the microscope. For this reason, in a typical calibration scheme, every element or nearly every element is calibrated for the same energy as the beam energy. For example, demagnification elements and magnification elements are calibrated for the same beam energy. This approach is described further in reference to FIG. 4A.

The detector section 110 includes one or more types of detector, sensor, screen, and/or optics configured to generate images, spectra, and other data for use in sample imaging and/or microanalysis. For example, the imaging section can include a scintillator screen, binoculars, transmission electron microscopy (TEM) detector(s) (e.g., pixelated electron detector, secondary electron detector, camera(s), and electron energy loss spectroscopy (EELS) spectrometer(s) 115, among others. The EELS spectrometer 115 functions as an energy filter at least in part by focusing the beam of electrons onto an electrostatic or magnetic dispersive element (also referred to as a "prism") that deflects the electron proportional to the energy of the electron. In this way, electrons that have transferred energy to the sample (e.g., by inelastic collision(s)) can be redirected through the magnetic dispersive element and toward a detector. The detector can include a pixelated detector (e.g., a CCD device configured to detect electrons) that generates one- or two-dimensional EELS data, from which EELS spectra can be derived. In some embodiments, EELS spectrometer(s) 115 also include one or more optical elements, such as electromagnetic or electrostatic lenses and/or multipoles and/or accelerators, to condition and/or focus the scattered electrons onto the detector.

FIG. 2 is a schematic diagram illustrating principles of operation of an example charged particle beam system 200, in accordance with some embodiments of the present disclosure. The example system 200 is an example of the charged particle beam system 100 of FIG. 1, and includes a microscope 201, corresponding to the source section, the TEM column 105, the sample section 107 and, in some cases, part of the detector section 110 of charged particle microscope 100. The example system 200 also includes the spectrometer 115, in the illustrated embodiment represented by components of an EELS spectrometer. The example system 200 also includes elements of a control system 210, being operably coupled with the microscope 201 and the spectrometer 115.

The microscope 201 can include a source of charged particles 205 configured to generate a beam of charged particles 215 (e.g., electrons or ions) of a first energy $E1$. A fraction of particles can be scattered by the sample. The scattering events can include inelastic scattering. In the technique of electron energy loss spectroscopy (EELS), an EELS spectrometer 115 can be used to measure the energies of inelastically scattered electrons, from which an energy loss $\Delta E$ can be derived, associated with inelastic scattering events. An electron that has lost energy during an inelastic scattering event travels through the TEM column and through the EELS spectrometer at an energy of $E1-\Delta E$. The magnitude of the deviation from the energy $E1$ for which the TEM column and EELS spectrometer have been calibrated influences the effect of the charged particle optical elements on the electron as it travels between the sample and a detector 245 of the EELs spectrometer 115. The deviation $\Delta E$ from the calibration energy causes the forces applied by charged particle optical elements to deviate from their respective calibrated optical strengths, resulting in impaired imaging performance.

For example, where $\Delta E$ includes a range of energy-loss values, a number of imaging planes can be defined by the energy-dependent performance of charged particle optical elements. While a portion of the scattered electrons can be focused onto the detector, in line with the calibration of the system, some electrons can be focused onto image planes at positions upstream of the detector, downstream of the detector, or at positions away from the entrance of the spectrometer (e.g., off axis). In some cases, scattered electrons can be steered into contact with internal surfaces of the TEM column or the spectrometer, thereby being eliminated from the EELS signal entirely.

For calibration schemes described above, illustrated in more detail in FIG. 4A, it is typically possible to detect electrons having energies that deviate from the calibrated energy by as much as $\Delta E/E1 \approx 2\%$, provided the lens settings of the column are carefully chosen and provided that multipole settings in the spectrometer are carefully chosen. That being said, for values of $\Delta E$ larger than approximately 1% of the calibration energy $E1$ (i.e., $\Delta E/E1 >\sim 1\%$), the calibration schemes described above fail to direct scattered electrons through the charged particle optical elements of the TEM column and through those of the EELS spectrometer without introducing artifacts (e.g., over/under magnification and/or deviations from the beam position). Deviations in the magnification and position of the beam results in inefficient collection of scattered electrons by the EELS spectrometer. Further, aberrations that exclude a portion of scattered electrons from detector signals impair the usefulness of recorded EELS spectra for properly and reliably quantifying the elemental composition of the sample. With greater deviation from the beam energy, such challenges become more significant.

In some embodiments of the present disclosure, electrons deviating from the beam energy ($E1$) by equal to or more than about 1% (e.g., $\Delta E/E1 \geq\sim 1\%$) can be efficiently collected by employing a different calibration scheme to those described above, for which a second calibration energy $E2$ is used for one or more charged particle optical elements downstream of the sample. Further, the calibration scheme can include configuring one or more projection optics (e.g., projection optics system 111 of FIG. 1) to maintain one or more constraints of the optical arrangement (e.g., focal plane positions, crossover positions, etc.) while immersing the sample in an objective field, as described in more detail in reference to FIGs. 4A-4D.

Generally, according to the present disclosure, one or more charged particle optical elements 220 are calibrated for a first energy $E1$ and one or more charged particle optical elements 230 are calibrated for a second energy $E2$. In some embodiments, the optical element(s) 220 calibrated for the first energy $E1$ is/are upstream of a sample 225 disposed in a sample section (e.g., sample section 107 of FIG. 1), optical elements 221 and 223, representing magnetic immersion objective lenses (e.g., objective lenses 108 and 109 of FIG. 1) are also calibrated for the first energy $E1$, and the optical element(s) 230 calibrated for the second energy E2 is/are downstream of the sample 225. The first energy E1 and the second energy E2 can be different, for example, E1 can be greater than E2. Electrons having an energy about the first energy E1 upstream of the specimen that lose energy ($\Delta$E) by scattering will have an energy about E1-$\Delta$E downstream of the specimen. To that end, E2 can be selected such that E2 is equal to about E1-$\Delta$E. In some embodiments, E2 can be determined using the absolute value expression: $|(\Delta E+E2-E1)/E2| \leq$ about A, where A is a value from about 1% to about 10%, including subranges, fractions, and interpolations thereof. For example A can be equal to about 1%, about 2%, about 3%, about 4%, about 5%, about 6%, about 7%, about 8%, about 9%, about 10%, or the like.

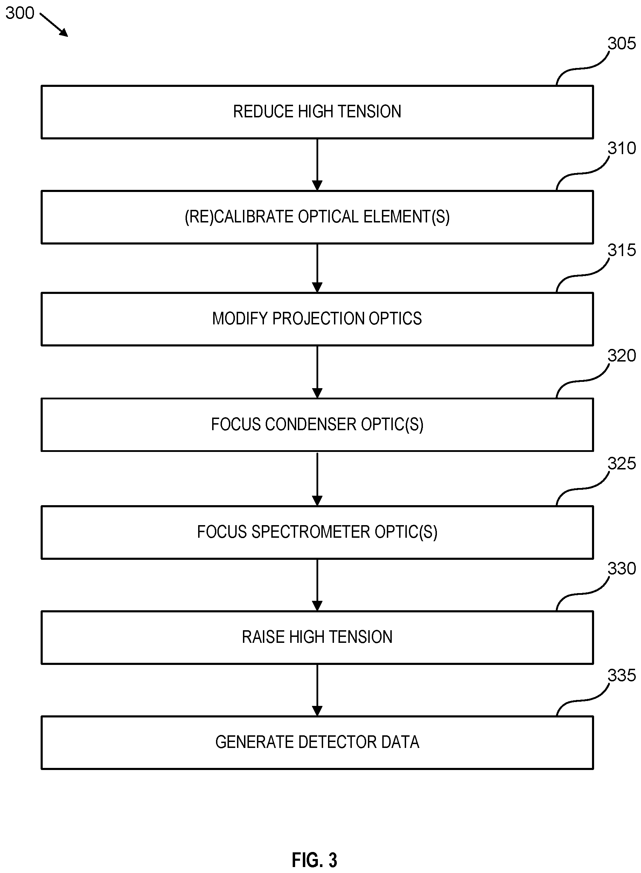

In the illustrative examples of FIGs. 3-6, the difference between E1 and E2 can be from about 2 keV to about 50 keV, including subranges, fractions, and interpolations thereof. For example, the difference between E1 and E2 can be from about 2 keV to about 35 keV, from about 2 keV to about 10 keV, about 10 keV, about 20 keV, about 30 keV, or the like. The energies E1 and E2 can be from about 50 keV to about 500 keV, including subranges, fractions, and interpolations thereof. In an illustrative example, E1 can be about 300 keV and E2 can be from about 270 keV to about 295 keV, including subranges, fractions, and interpolations thereof (e.g., about 290 keV). In another example E1 can be about 310 keV and E2 can be about 300 keV. In another example, E1 can be about 200 keV and E2 can be about 190 keV. The cross section for a given excitation (e.g., an inner-shell ionization) can depend at least in part on $\Delta$E. To that end, for values of $\Delta$E outside the stated range, high-energy loss data can be dominated by noise, based at least in part on the relatively low probability of a charged particle to induce the given excitation.

A difference between the first energy and the second energy can depend at least in part on the value of the first energy. For example, the second energy can be a fraction of the first energy. In some embodiments, the second energy can be from about 60% to about 99% of the first energy, including subranges, fractions, and interpolations thereof. In an illustrative example, the second energy can be from about 90% to about 98.5% of the first energy. The difference between the first and second energy can be chosen to be equal or approximately equal to the energy loss that is to be recorded by the EELS spectrometer. The techniques described herein permit charged particle microscopes to interrogate energy ranges corresponding to relatively high energy losses, where a larger difference between E1 and E2 will result in detector data (e.g., extended energy loss fine structure, or EXELFS) that corresponds to an excitation energy of a scattering event of about the value of the difference. In this way, a difference of about 10 keV can provide detector data for scattering events having an excitation energy of about 10 keV.

In EXELFS, the fine structure in the energy-dependence of the probabilities of core-shell excitation is studied. The total number of electrons $N_{tot}$ that experience an energy loss due to the excitation of a core-shell scales approximately with the energy loss to the power - 1.5, that is, $N_{tot} \propto \Delta E^{-1.5}$. In this way, the number of scattered electrons can be distributed over a range $\Delta E_{tail}$ of energies (known as the 'tail of the edge') and over a range $\Delta \vartheta$ of scattering energies (known as the 'scattering distribution'). The range of scattering angles is roughly equal to $\Delta \vartheta_{mean} = \Delta E/2/E1$. When these expressions are combined, it can be estimated that the number of energy-lost electrons in a specific energy interval dE and in a specific solid angle $d\Omega=(d\vartheta)^2$ scales with the energy loss as described in the expression:

$$N_{tot} \cdot dE \cdot d\Omega \; \propto \; \Delta E^{-1.5} \cdot (d\vartheta/\Delta \vartheta_{mean})^2 \; \propto \; \Delta E^{-3.5}$$

This estimate shows that the EXELFS signal in an EELS spectrometer rapidly drops with increasing energy loss. For example, in order to reach the same number of counts (and hence the same statistics) in the EXELFS region (100 eV wide) for the K-shell edges in titanium (5.0 keV), copper (9.0 keV), molybdenum ($\Delta$E = 20 keV), and antimony ($\Delta$E = 30.5 keV), the implicated beam dose scales (relative to Ti) by the ratios of 1:8:128:560. In this way, collection solid angle of the EELS spectrometer can determine to a large part the performance of a TEM system in measuring EXELFS spectra. Advantageously, collection solid angle improves significantly when the TEM column is calibrated to better collect scattered electrons in accordance with the expression $|(\Delta E+E2-E1)/E2| <\sim 2\%$. In this way, calibration processes of the present disclosure can include measuring the collection angle and centering the beam with respect to the EELS spectrometer. With respect to edge position or edge structure, noise can become more significant at larger values of the difference between E1 and E2, such that beyond about $\Delta$E = 30 keV, integration time and total electron dose can be limited, for example, by sample sensitivity.

The spectrometer 115 can include charged particle optical elements, such as a dispersive element 235 and one or more electromagnetic and/or electrostatic elements 240 (e.g., lenses, accelerators, quadrupoles, hexapoles, octupoles, etc.). The dispersive element 235 can comprise one or more magnetic and/or electrostatic dispersive elements (also referred to as "prisms"). The spectrometer 115 can be post-column (located after the TEM column as in Figure 2) or it can be in-column, operably coupled with the TEM column. The elements 235 and 240 can be calibrated for the second energy E2. In reference to the dispersive element 235, calibration for the second energy E2 refers to the operation of the dispersive element 235 to disperse charged particles (e.g., electrons) having an energy that deviates from E2 by not more than about 2% of E2. In this way, charged particles having an energy of about E2 can be transmitted to elements 240 and subsequently directed to a detector 245 of the spectrometer 115. In some embodiments, the elements 240 also focus the charged particles onto the detector 245.

Other components of the system 200 can serve to attenuate, redirect, absorb, or otherwise exclude from detector data, un-scattered 250 or weakly scattered charged particles 255 (e.g., electrons that transit the sample 225 without scattering). For example, element(s) 230 can apply a force to electrons that is proportional to the velocity of the electrons (e.g., a magnetic force), which redirects electrons having an energy of about E1 away from a beam axis and into an absorber material or other surface internal to the microscope 201.

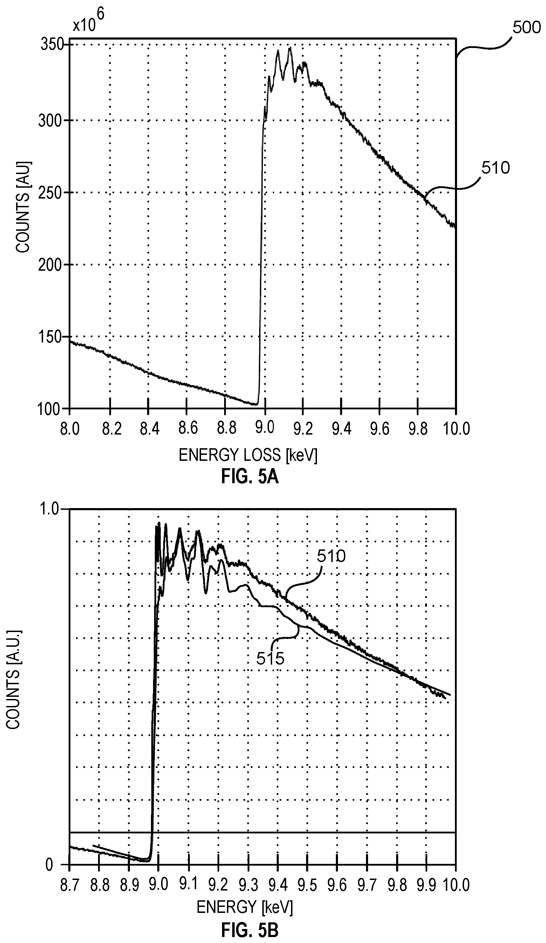

The detector 245 can generate detector data. As described in more detail in reference to FIGs. 3-6, detector data can include EELS spectra resulting from interactions between the beam of charged particles 215 and atoms 227 of the sample 225. For example, where the microscope 201 is operating in STEM mode (e.g., scanning TEM or STEM-in-SEM) and the sample 225 is thinned to permit the transmission of the beam, a beam of electrons can focus onto a point in the sample 225 that permits the measurement of single atoms or groups of atoms on a nanometer scale. As described in more detail in reference to FIGs. 5A-5B, interactions between neighboring atoms 227 can introduce fine structure into detector data. In this way, detector data can be used to derive chemical, physical, and/or structural information about the atoms 227 (e.g., oxidation state, coordination information, etc.). Advantageously, embodiments of the present disclosure combine fine-structure information with spatial localization, which is unavailable in typical synchrotron systems used for generating comparable detector data. In a TEM operating in STEM mode, atomic scale resolution can be obtained by focusing the beam of charged particles 215, permitting the system 200 to be used to generate nanometer-scale maps of material properties of the sample 225.

The control system 210 can include one or more machines (e.g., computing devices) that are operably coupled with control circuitry disposed in the microscope 201 and/or the spectrometer 115. In an illustrative example, control circuitry can include an arrangement of circuit components connected to a power source and configured to control the application of power (e.g., voltage and or current) to the source, the elements 220, 230, 235, 240, and/or the detector 245. In this way, processes for calibrating and/or recalibrating the elements 220, 230, 235, 240, and/or the detector 245 can be orchestrated by the control system 210, in accordance with one or more operations encoded in machine-executable instructions stored on one or more machine-readable storage media (e.g., local storage media, distributed "cloud" storage media, etc.). The one or more machines can include, but are not limited to, personal computers, laptops, tablets, servers, application specific machines (ASMs), or the like. In some embodiments, the control system 210 includes user-interactable elements, such as a display and input peripherals (e.g., mouse and keyboard), through which a user can reversibly implement a high-energy-loss EELS mode, in accordance with the operations described in reference to FIG. 3. In an illustrative example, a user can select an interactive graphical element 211 on a user interface (e.g., in an application, browser environment, etc.) that initiates the high-energy-loss EELS mode. To return the system 200 to its prior state, the user can select an interactive graphical element 211 that initiates a calibration of the elements back 220, 230, 235, and/or 240 from E1 or E2 back to the prior calibration energy (e.g., the first energy E1, the second energy E2, or a third energy E3).

To that end, processes of the present disclosure (e.g., example process 300 of FIG. 3) can include operations for receiving user interaction data (e.g., via an interactive user interface), where the interaction data corresponds to an action by a user to initiate or reverse a recalibration of one or more elements of the charged particle beam system. Similarly, the processes of the present disclosure can include generating user interface data configured to modify a display (e.g., of control system 210) to present an interactive user interface.

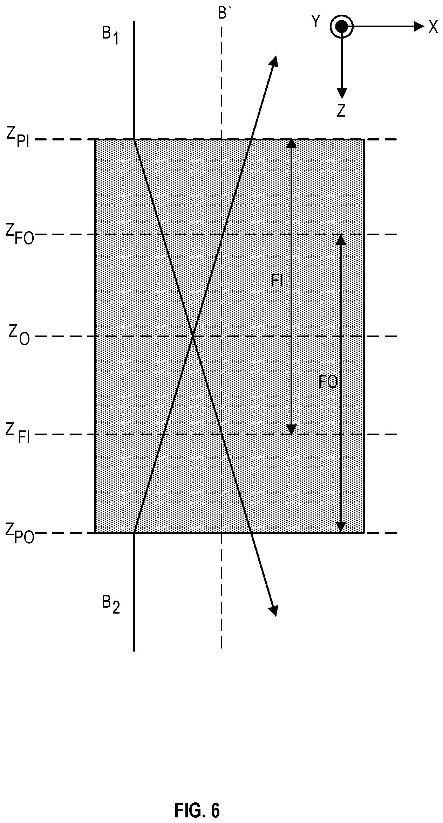

In some embodiments, the control system 210 is configured to communicate with one or more datastores and/or machine-readable media storing instructions encoding one or more algorithms for generating a set of operating conditions for at least a subset of the optics in the column (e.g., TEM column 105 of FIG. 1). As described in more detail in reference to FIG. 3 and FIG. 6, the control system 210 can be configured to generate and/or implement a set of operating conditions such that at least a subset of the optics disposed downstream of the sample 225 can be calibrated for the second energy E2 and the optics disposed upstream of the sample 225 can be calibrated for the first energy E1. Advantageously, the techniques of the present disclosure permit one or more optics downstream of the sample to be calibrated for the first energy E1, such as the objective imaging lens 223 (e.g., objective lens 109 of FIG. 1). In this way, a charged particle beam system provided with a magnetic immersion objective, as is typical for STEM-configured TEM instruments, can maintain a common calibration scheme for the objective condenser lens 221 and the objective imaging lens 223 (e.g., calibrated for the first energy E1). In some embodiments, control system 210 can be configured to generate the set of operating conditions by communicating with a physically remote computing system (e.g., a distributed computing system) and/or can execute one or more of the algorithms locally, based at least in part on the computational and/or network resources available to the control system 210.

FIG. 3 is a block diagram illustrating an example process 300 for interrogating a sample with a charged particle beam system, in accordance with some embodiments of the present disclosure. One or more operations of the example process 300 may be executed by a computer system in communication with additional systems including, but not limited to, characterization systems, network infrastructure, databases, and user interface devices. In some embodiments, at least a subset of the operations described in reference to FIG. 3 are performed automatically (e.g., without human involvement) or pseudo-automatically (e.g., with human initiation or limited human intervention). In an illustrative example, operations for generating and shaping a beam of electrons can be executed automatically, with the TEM system 100 being configured to maintain properties of the beam of electrons at or about a set point that can be designated by a human user. In another illustrative example, a human user can initiate an EELS mode using the techniques described herein by activating a subsystem of the charged particle microscope 100 (e.g., through an interactive user environment presented through a user terminal, such as a browser or software application, and/or a push-button control panel) that initiates recalibration of the charged particle microscope 100 from imaging mode or conventional EELS mode (i.e., all elements calibrated for the same energy) to high-loss mode (i.e., some elements calibrated for an energy E1, other elements calibrated for an energy E2). To that end, while example process 300 is described as a sequence of operations, it is understood that at least some of the operations can be omitted, repeated, and/or reordered. In some embodiments, additional operations precede and/or follow the operations of example process 300 that are omitted for clarity of explanation, for example, operations for calibration of the electron source, alignment and aberration correction of the beam of electrons, loading a sample into a sample position, equilibrating a vacuum system, or the like. Advantageously, embodiments of the present disclosure maintain the spatial resolution of charged particle beam systems operating in scanning mode (e.g., STEM mode for TEM instruments) for which the sample is immersed in an objective field. Further, the implementation of algorithmic tuning of the projection optics to compensate for the effect of the objective field permits the methods of the present disclosure to be at least partially automated, thereby significantly reducing the complexity of enabling high-loss EELS mode. Finally, the example process 300 provides a significant improvement to the energy resolution of EELS data at energy losses greater than about 1% of the beam energy and resolved most, if not all artefacts of measuring such data under typical STEM mode, thereby enabling fine-structure analysis (EXELFS) that is typically performed using synchrotron instruments.

At operation 305, example process 300 includes reducing a high tension applied to a charged particle source (e.g., charged particle source 103 of FIG. 1, charged particle source 205 of FIG. 2). In this context, "high tension" (or, in short, "tension") can refer to an accelerating voltage or other operating parameter describing an energy of the charged particles emitted by the source into the column (e.g., TEM column 105 of FIG. 1). For example, the energy E of an electron beam is described by the accelerating voltage V through $E = e \cdot V$ where e is the electron's charge. In this way, operation 305 can include modifying the operating voltage of the charged particle source from the first energy E1, described in reference to FIG. 2, to the second energy, E2. In some embodiments, operation 305 includes reducing the tension from 300 kV by a proportion from about 1% to about 20%, including subranges, fractions, and interpolations thereof. The extent to which the tension is modified can correspond to an energy loss to be interrogated. For example, in the embodiment described in reference to FIGs. 5A-5B, the accelerating voltage of an electron source was reduced by about 9 kV, corresponding to a characteristic edge of an inner shell ionization of copper atoms (the Cu k edge at 8987.96 eV). Similarly, an element of interest in a material sample can be analyzed by modifying the tension by a value corresponding to the characteristic energy of a given inelastic transition for that element, as part of the example process 300. Further, operation 305 can be repeated for multiple energy values, as part of an iterative approach to improving the energy resolution and signal-to-noise characteristics of EELS detector data. Advantageously, this approach improves the resolution of fine-structure in EELS data for relatively large energy loss values (e.g., greater than about 1 keV).

At operation 310, example process 300 includes calibrating and/or recalibrating one or more charged particle optical elements. Elements 220, 230, 235, and 240 of FIG. 2 are examples of the charged particle optical elements of operation 310. In general, calibrating and recalibrating can include one or more sub-operations including modifying electrical parameter(s) of the elements to bring the elements to a set of operating conditions, such as magnification and position of the charged particle beam at the EELS spectrometer, or magnification and width of the dispersed charged particle beam at the detector. In the context of the present disclosure, operation 310 can include the same or similar sub-operations applied to shift the calibration energy of the elements from a first energy (e.g., E1 of FIG.2) to a second energy (e.g., E2 of FIG.2). In this way, operation 310 can include recalibrating the elements 220 for a higher energy, recalibrating the elements 230, 235, and 240 for a lower energy, or both. In this context, the term "calibration energy" refers to a set of operating parameter(s) that configures the charged particle optical elements to apply an appropriate force on a beam of charged particles (e.g., beam of charged particles 215 of FIG. 2) at or about the calibration energy, as part of defining one or more beam crossovers at positions on a beam axis of the column, as described in more detail in reference to FIGs. 4A-4E. As electrostatic elements can apply a refractive effect that is inversely proportional to the energy of the beam (ignoring relativistic effects) and magnetic elements can apply a refractive effect that is inversely proportional to the square root of the energy of the (ignoring relativistic effects), mis-calibrated elements can exhibit impaired performance for a given energy of the beam. In an illustrative example where the optical element is a condenser lens, a beam of electrons can be underfocused or overfocused by about 100 nanometers when the lens is mis-calibrated by as little as 10 eV.

At operation 310, shifting of the calibration from a first energy (e.g., E1) to a second energy (e.g., E2) can be performed using energy-scaling-behavior of the charged partical optical elements. For example, a magnetic multipole element can be recalibrated from energy E1 to energy E2 by scaling its known calibration at E1 by a factor $\sqrt{(E1/E2)}$ (ignoring relativistic effects). As part of such scaling of the calibration, magnetic elements can be operated, configured, or otherwise conditioned to be substantially free of magnetic saturation and hysteresis. Scaling can also be applied to beam deflectors and beam stigmators, where the mechanical alignment of the optical elements can be improved in this way.

In conventional EELS mode, the optical elements 220, 230, 235, and 240 can be calibrated for a first beam energy (e.g., about 300 keV), generated by the source of charged particles 205 (illustrated in FIG. 4A). In contrast, example process 300 can improve resolution of EELS data at relatively high energy losses by (re)calibrating additional and/or alternative optical components, and by operating at least a subset of the optical elements 220, 230, 235, and 240, at the calibration parameters for the first energy E1 and a second subset at about the second energy E2. In some embodiments, one or more constituent elements of the projection optics assembly (e.g., projector optics 111 of FIG. 1) are (re)calibrated as part of operation 310. In an example, the projector optics can include a diffraction lens, an intermediate lens, and two projector lenses. To that end, the example process can include, at operation 315, modifying one or more elements of the projection optics assembly to calibrate the assembly for the second energy E2. The result of the modification(s) (e.g., as a combined effect of multiple changes to the operating parameters of multiple optics) can serve to compensate for changes to the beam of charged particles resulting from calibrating charged particle optics for the second energy (e.g., the optics of the spectrometer). This enables a different energy loss, relative to the zero-loss peak (ZLP) energy of the source. The influence of optical element calibration on the optical ray paths in an example TEM system is described in more detail in reference to FIGs. 4A-4D.

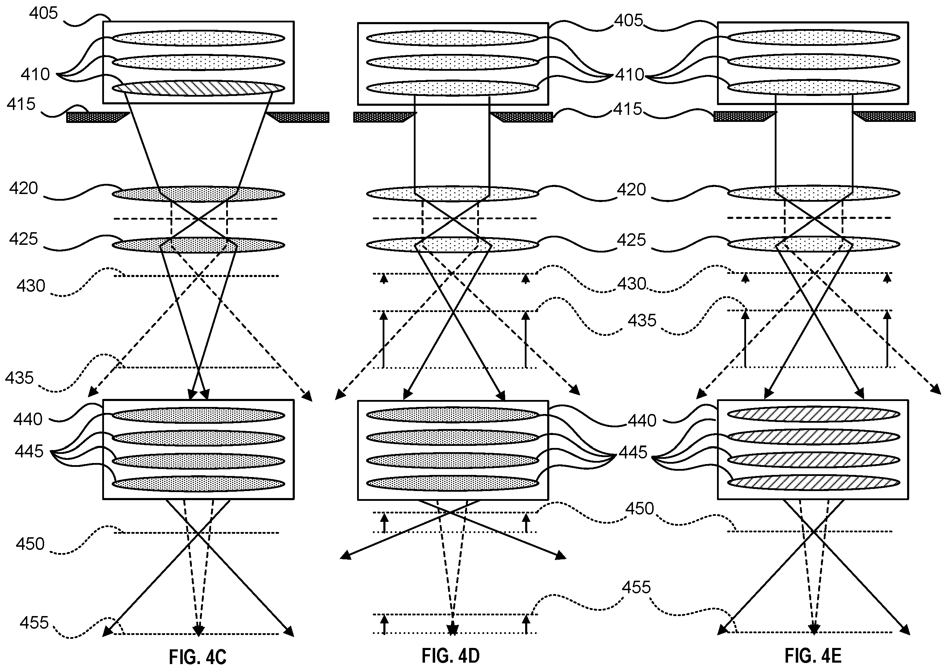

Operation 315 can include one or more sub-operations for generating a set of operating conditions for the projection optics system. Generating the set of operating conditions can include determining a solution for a first order approximation of the projection optics assembly, as described in more detail in reference to FIG. 6. As illustrated in FIG. 4D, the solution can configure the projection optics to define one or more beam crossovers substantially coinciding with corresponding positions for the operation of the charged particle microscope at an accelerating voltage about the first energy, as illustrated in FIG. 4A. Advantageously, the set of operating conditions generated in operation 315 can permit the projection optics to compensate for the effect of an objective lens assembly being maintained at the first energy, including an objective lens disposed downstream of the sample position (e.g., objective imaging lens 109 of FIG. 1, objective imaging lens 223 of FIG. 2) that would otherwise shift the position of the one or more beam crossovers, as illustrated in FIG. 4C and adversely effect the resolution of a detector downstream of the sample.

In some embodiments, operation 315 can be implemented as an algorithm at least partially encoded in software or other programmable logic. For example, a dataset of operating conditions for the projection optics system can be structured as a lookup table or other datastore. The dataset can describe multiple sets of operating conditions for the projection assembly associated with one or more accelerating voltages. In this way, determining the solution can include referencing the dataset of operating conditions for the charged particle beam system using the second energy as an input parameter. In some embodiments, determining the solution includes solving a mathematical expression describing the first order approximation of the projection lens assembly. Solving the mathematical expression can include implementing one or more computational techniques for solving coupled systems of optics equations, as described in more detail in reference to FIG. 6.

In some cases, the first order approximation of the projection optics assembly can have multiple solutions, among which one or more can be relatively more physically meaningful. As an example, a mathematically correct solution can define beam paths that intersect with physical constraints of the charged particle beam system. As such, generating the set of operating conditions can include defining a physically meaningful solution.

At operation 320, example process 300 includes focusing one or more condenser optic(s) of the charged particle beam system. Charged particle beam systems can include one or more optics configured to function as condenser lenses with respect to the refractive action imparted on a beam of charged particles. In this context, a condenser optic imparts an electromagnetic force on a beam of charged particles to render a diverging beam into a parallel or converging beam. Focusing the condenser lens(es) can include modifying one or more operating parameters of the condenser optic(s) such that a beam of charged particles at the second energy E2 approaches a probe forming optic (e.g., condenser objective lens 108 of FIG. 1, objective condenser lens 221 of FIG. 2) while substantially parallel or converging toward the beam axis. In this way, the probe forming optic can be configured to focus a beam of charged particles at the second energy E2 onto the sample position. Focusing the beam of charged particles onto the sample position can correspond to a fine focus at a spatial resolution of about 0.5 nm or less, including fractions thereof (e.g., about 0.1 nm or less, about 0.05 nm thereof, etc.). Advantageously, example process 300 can be relatively robust to the specific operating parameters of the condenser optic(s), based at least in part on the compensating effect of the modifications made to the projection optics in operation 315.

At operation 325, example process 300 includes focusing one or more charged particle optical elements of the EELS spectrometer (e.g., spectrometer 115 of FIG. 1 and FIG. 2). In this context, focusing can include modifying one or more operating parameters of the elements (e.g., elements 235 and/or 240 of FIG. 2) such that a beam of charged particles can define a crossover at a position on the axis of the spectrometer such that the beam of charged particles will impinge on a detector (e.g., detector 245 of FIG. 2) while being dispersed by energy along a spatial direction, as described in reference to FIG. 2.

At operation 330, example process 300 includes modifying the tension of the charged particle source. As part of the operating arrangement described in reference to FIG. 2 and FIG. 4E, a portion of the elements of the charged particle beam system are configured for a beam of charged particles about E1, and a second portion of the elements are configured an energy E2. The combined effect of these two configurations are that the charged particles at about E2 are define one or more crossovers at appropriate positions for the corresponding positions of detectors, apertures, etc., described in reference to FIGs. 4A-4E. To that end, the source of charged particles can be modified to the first energy, E1, from the tension setting defined in operation 305. In some embodiments, example process 300 includes modifying a calibration of the condenser optic(s) from the second energy E2 to the first energy E1. Recalibration of the condenser optic(s) can be carried out concurrently with operation 330.

At operation 335, example process 300 includes generating detector data. Detector data can include EELS data generated by coupling the beam of electrons (e.g., beam of charged particles 215 of FIG. 2) into an EELS spectrometer (e.g., EELS spectrometer 115 of FIG. 1). To that end, operation 335 can include generating a beam of charged particles. In the example of a transmission electron microscope (TEM), operation 335 can include activating an electron emitter (e.g., source of charged particles 205 of FIG. 2), in accordance with a set of parameters that will result in the beam of charged particles having an energy about the first energy to be directed through a sample position and toward the detector section of the charged particle beam system (e.g., detector section 110 of FIG. 1). In some embodiments, operation 335 includes generating a beam of charged particles having an energy of about 300 keV, or of about 200 keV, or of about 60 keV

A result of operation 305 can be that the portion of the beam of electrons having an energy about the second energy are directed toward the detector (e.g., detector 245 of FIG. 2) and the portion of the beam of electrons scattered by an energy different from the second energy by an extent greater than about $0.02 \cdot E2$ are blocked or otherwise defocused or otherwise redirected away from the detector 245, either by the microscope (e.g., the TEM column 105 of FIG. 1 and the microscope 201 of FIG. 2) or by components of the spectrometer (e.g., energy dispersive filter 235).

In some embodiments, one or more operations of example process 300 can be repeated in one or more iterations as part of generating a dataset of EELS spectra for a given sample or for multiple samples. For example, operations 305-315 can be repeated over a range of second energy values for a given first energy value. In this way, the difference between the first energy and the second energy can be varied over a range, for example, as part of a characterization of a sample to detect and identify elements present in the sample (e.g., by measuring inner shell ionization edges in EELS data at multiple energies). In another example, operation 315 can be repeated at multiple points on a sample surface, as part of generating an EELS datacube mapping out chemical and/or physical data for the sample. In this context, a "datacube" refers to a hierarchical data structure in which EELS data are referenced to one or more pixels of an image of a sample surface, as part of "mapping" the surface of the sample (e.g., with elemental information).

Advantageously, the presence of fine-structure in EELS data generated using the techniques described herein permits localized structural information to be derived, for example, by fitting one or more models to the detector data from which bonding information, oxidation state, or other physical and/or chemical properties of the sample can be derived. Analogous models used for extended x-ray absorption fine structure (EXAFS) analysis can be used to determine interatomic spacings (e.g., using EXELFS models), oxidation state, band structure, and/or coordination information (e.g., crystal structure, bonding, or the like). As the spatial resolution of EELS systems in STEM mode can be on the order of single atoms, EELS data generated using example process 300 can be used to map chemical, physical, and/or structural information over a region of a sample surface.

FIGs. 4A-4E are schematic diagrams illustrating an example optical system 400 of a charged particle beam system, in accordance with the current art. The optical arrangements in FIGs. 4A-4E include a condenser system 405 of one or more condenser optics 410, a beam limiting aperture 415, a probe-forming objective lens 420, an imaging objective lens 425, and a projection optics assembly 440 including one or more projector optics 445. The components of the example optical system 400 can be configured in accordance with respective operating parameters that together shape, form, and/or modify a beam of charged particles such that the beam defines one or more crossovers along a beam axis, B, including an objective crossover, an imaging crossover, and/or a final crossover. A crossover can be real, corresponding to a position on the beam axis, B, at which the beam converges to a point or line (e.g., a focal point located at a position where the particle beam is actually focused) or virtual, corresponding to a position on the beam axis, B, at which the beam would converge to a point or line, where it now for the action of an optical element (e.g., located beyond or in front of a lens that refocuses the beam before real crossover would otherwise occur). One or more constraints of the charged particle beam system can define a set of planes along the beam axis, B, including a specimen plane 421, a back focal plane (BFP) 430, a first image plane (FIP) 435, a final cross-over (FXO) plane 450, and a detector plane 455.

The configuration of the various components of the example system 400 can be constrained at least in part by the operating mode of the charged particle beam system. For example, in STEM mode the projection optics assembly 440 and constituent projection lenses 445 can be modified to a set of operating parameters that satisfies the following four boundary conditions: the FIP 435 is imaged to the FXO 450, permitting the FXO 450 to act as an input image for a spectrometer (e.g., the spectrometer 115 of FIG. 1); the BFP 430 is imaged to the detector plane 455; the camera length, or magnification, at the detector ($M_{PROJ}$) satisfies a given value (e.g., 40 mm); and the image orientation at the detector plane 455 satisfies a given value (e.g. 180°). The different sets of conditions described in reference to FIGs. 4A-4D, respectively, illustrate different approaches to operating a charged particle beam system in STEM mode. To that end, FIG. 4A illustrates a typical STEM configuration, FIG. 4B illustrates an example configuration for energy loss spectroscopy at relatively large energy losses in field-free mode or with inconsistent calibration of the objective optics, FIG. 4C illustrates operating in immersion-mode (maintaining a consistent calibration for the objective lenses 420 and 425 on either side of the specimen plane 421), and FIG. 4D illustrates improvements to immersion-mode with generating a set operating conditions for the projection optics, in accordance with embodiments of the present disclosure. In FIGs. 4A-4D, fill patterns in the various lens ellipses represent calibration states, where two lenses having a common fill pattern are calibrated for a substantially equal beam energy. In an illustrative example, the condenser system 405 of FIG. 4C is calibrated for a first energy, E1, and is filled with a first fill pattern, while the projection optics assembly 440 is calibrated for a second energy, E2, and is filled with a second fill pattern.

FIG. 4A illustrates the condition where the optical elements are consistently calibrated for the source tension (e.g., 300kV). The solid rays represent the probe forming trajectories, defining a first cross-over at the specimen plane 421, a second crossover at the first image plane (FIP) 435, and the final crossover (FXO) 450 between the projection optics assembly 440 and the detector plane 455. The dashed rays represent scanning trajectories in STEM mode, defining a first crossover at the back-focal plane (BFP) 430 and a second crossover at the detector plane 455. As described in reference to FIG. 2, EELS data are limited to within about 1% of the beam energy in this configuration, based at least in part on on the increasing significance of aberrations and decreasing signal to noise as the energy loss value increases.

FIG. 4B illustrates an operating configuration for generating large-energy loss (XEELS) data with an inconsistent calibration across the objective lenses. In this configuration, the optics upstream of the specimen plane 421 (e.g., the condensor system 405, the probe-forming objective lens 420) are calibrated for a first energy E1, and the optics downstream of the specimen plane 421 (e.g., the projection optics assembly 440, the imaging objective lens 425, etc.) are calibrated for an energy that reflects the energy loss of interest (e.g., an energy loss of 10 kV applied to a first energy, E1, of 300 kV provides a second energy, E2, of 290 kV). Advantageously, this configuration provides for the transfer of charged particles to the sample plane 421 without addressing individualized adjustment of the component lenses 405 of the illuminating optics system 405 and 420. In this way, the approach illustrated in FIG. 4B can be successful and advantageous in terms of time and complexity in charged particle beam systems for which the objective lens systems can be calibrated for different beam energies, as in non-immersion mode. However, for magnetic immersion objective lenses, the objective lenses 420 and 425 are constrained to a consistent calibration energy for immersion-mode (and including a spherical aberration corrector in some cases). To that end, the probe forming objective lens 420 must be calibrated for the second energy, despite being disposed upstream of the specimen plane 421. Thus the operating configuration in 4B cannot be applied in immersion-mode.

FIG. 4C illustrates an operating configuration for generating large-energy loss (XEELS) data in immersion mode. In this configuration, the optics downstream of the specimen plane 421 (e.g., the projection optics assembly 440, the specimen objective lens 425) are calibrated for an energy that reflects the energy loss of interest (e.g., an energy loss of 10 kV applied to a first energy, E1, of 300 kV provides a second energy, E2, of 290 kV). Advantageously, the configuration provides for the transfer of charged particles to the detector plane 455 without addressing individualized adjustment of the component lenses 445 of the projection optics system 440. However, the probe-forming objective lens 420 is constrained to be calibrated at the same second energy E2. Since the calibration of lens 420 (at energy E2) no longer matches the energy E1 of the beam in lens 420, the condenser assembly 405 and objective lens assembly (comprising several deflectors and stigmators (not shown in FIG. 4) and objective lens 420) are retuned to achieve atomic resolution (e.g., sub-Angstrom) of the electron microscope.

Such retuning of the condenser assembly and of the objective lens assembly can be time consuming. Further, some charged particle beam systems can include a probe-forming objective lens 420 for which the operating window doesn't include the set of parameters that would permit it to be calibrated for the second energy, E2. In such cases, one or more condenser optics 410 can be modified to accommodate the constraint imposed by the probe-forming objective 420. Such manual recalibration can be technically complex and time consuming, especially when scaled by generating large energy loss EELS ("XEELS") data at more than one energy difference.

FIG. 4D illustrates a configuration that reflects the consequences of maintaining an objective field calibrated for the first energy, E1 (e.g., the specimen objective lens 425 being calibrated for the first energy, E1, despite being disposed downstream of the specimen plane 421). In this configuration, the specimen objective lens 425 is too strong for charged particles at the second energy, E2. The overfocus of the specimen objective lens 425 causes the crossovers at the FIP 435 and the BFP 430 to shift upstream, toward the specimen plane 421. The projection optics assembly 440, calibrated for the second energy E2, does not return the final crossover (FXO) 450 and the detector plane 455 to the positions corresponding to the constraints of $M_{PROJ}$. Typically, such shifts are relatively large (several millimeters or more at the FXO 450) and causes significant loss of signal and impaired resolution in EELS. Further, correcting for the shifts involves recalculating projector lens settings, a technically difficult operation that is time consuming and involves significant human involvement.

FIG. 4E is a schematic diagram illustrating charged particle optical elements of a charged particle beam system, in accordance with some embodiments of the present disclosure. FIG. 4E illustrates the objective lenses 420 and 425 operating with a consistent calibration to immerse the sample plane 421 in an objective field (e.g., both the upper and lower objective lenses are calibrated for the first energy E1). A consequence of this approach is that the image forming objective lens 425 is improperly calibrated for charged particles at the second energy E2, shifting the position of the first image plane (FIP) 435 significantly (the illustration of FIG. 4D is for a configuration where the second energy E2 is less than the first energy E1, shifting the FIP 435 toward the specimen plane 421). Embodiments of the present disclosure address the shifts, illustrated with vertically oriented arrows in FIG. 4E, at least in part by recalibrating the projector system 440, as described in more detail in reference to FIG. 3 and FIG. 6. An advantage of this approach is that STEM resolution is not affected and artefacts in XEELS data are reduced. The objective field can be maintained for the first energy (e.g., 300kV), and the projection optics assembly 440 can be recalibrated to accommodate for the XO shifts at the BFP and FIP.

In an illustrative example, where the number of projector lenses 445 matches the number of boundary conditions) one or more solutions are possible (e.g., the problem is fully defined). But finding appropriate solutions that satisfy the boundary conditions of the system is far from trivial because the problem is highly non-linear. Further, a solution should be such that higher-order aberrations are minimized and such that the beam does not impinge on inner surfaces of the optical system (e.g., TEM column 105 of FIG. 1).

In techniques of the current art, generating a single magnification setting that satisfies the boundary conditions can take a few hours (calculating and testing) and a series of good magnification settings can take weeks. For at least these reasons, magnification settings are typically pre-calculated, pre-tested, and pre-stored in magnification tables, significantly limiting the flexibility of STEM systems to respond to user input of energy loss data (e.g., energy difference, second energy E2, etc.) for which a pre-calibrated set of operating conditions is unavailable. To that end, techniques of the present disclosure can apply first-order transfer optics, parametrized thick-lens models, and solving algorithms to generate a set of operating conditions (e.g., projection lens settings) to satisfy the boundary conditions described above (e.g., attenuating aberrations and impingement on internal surfaces). In this way, the time to generate a new magnification setting is significantly reduced, from hours to fractions of a second.

FIG. 5A is a graph illustrating example electron energy loss spectrum (EELS) data 500 for a copper foil sample, in accordance with some embodiments of the present disclosure. The graph includes data for an inner shell ionization that is represented as an edge centered about 9 keV including fine structure. The graph plots the data 500 on a two-dimensional set of axes, with energy on the ordinate, over a range from about 8.0 keV to about 10.0 keV, and counts on the abscissa in arbitrary units (AU). In the example data shown, the EELS data 500 reproduce the positions of features of the fine structure present in EXAFS data, illustrated in detail in FIG. 5B.

In comparison, current techniques for measuring EELS data at similarly high energy losses typically result in significant signal-to-noise limitations because of mis-calibration of the solid angle collected by the EELS spectrometer (leading to inadequate collection angles), and to the introduction of aberrations in the TEM column and in the EELS spectrometer that negatively affect data quality, such as energy resolution. In accordance with the techniques described herein, such mis-calibrations and such aberrations are significantly reduced or removed, providing significant improvement to signal-to-noise characteristics of detector data and significant improvement of energy resolution, which together greatly facilitate EXELFS analysis.

FIG. 5B is a graph illustrating a detail of the example electron energy loss spectrum (EELS) data 510 for the copper sample of FIG. 5A with EXAFS data 515 superimposed, in accordance with some embodiments of the present disclosure. The data 510 present an EELS spectrum for the edge of copper at about 9 keV and represent a magnification of the fine structure present within about 0.3 keV of the edge position. The data 510 were acquired in 900 seconds with 2.3nA beam current, corresponding to a dose of 2.1 µC. The data 510 are presented to further illustrate energy loss values addressed by embodiments of the present disclosure. The counts values presented on the abscissa illustrate the improvement to signal-to-noise characteristics of relatively high energy loss edges, reinforcing the demonstration in FIG. 5A that includes fine structure from which physical structure information can be derived. Further, the improvement in the fine structure resolution further demonstrates the advantages of the present disclosure In the example data shown, the EELS data 410 reproduce the positions of features of the fine structure present in the EXAFS data 515.

FIG. 6 shows various parameters that can be used to describe first-order particle-optical effects of a thick magnetic lens, in accordance with some embodiments of the present disclosure. FIG. 6 schematically depicts electron rays B1, B2 and an optical axis B. As shown, various parameters are defined that can be used to provide a first-order description of a thick magnetic lens. The electron ray B1 that enters the lens from the top side (forward direction) parallel to the optical axis B' is refracted at the principal plane Zpi and crosses the optical axis B' at focal plane Zfi. The distance between Zpi and Zfi is defined as the focal length fi. The electron ray B2 that enters the lens parallel to the optical axis B' from the bottom side of the lens (backward direction) is refracted at the principal plane Zpo and crosses the optical axis B' at focal plane Zfo. If the potential is constant along the optical axis B', then fo=fi. In FIG. 6, Z0 denotes the geometric center of the thick lens.

The lens action between the two principal planes Zpi and Zpo can be described by the following matrix equation:

$$\begin{pmatrix} x(z = Zpi) \\ x'(x = Zpi) \end{pmatrix} = \begin{pmatrix} 1 & 0 \\ -\frac{1}{fi} & 1 \end{pmatrix} \cdot \begin{pmatrix} x(z = Zpo) \\ x'(x = Zpo) \end{pmatrix} \quad [1]$$

in which x and x' respectively denote the distance of a ray to the optical axis B' and the angle between the ray and the optical axis B'. Note that this equation describes the lens action from the object principal plane to the image principal plane of the lens, i.e., a ray coming from the top side of the lens in FIG. 6 moves to the Zpo plane first, where it virtually enters the lens, and virtually exits the lens at the Zpi plane, with unit magnification and an angle that is refracted by -x/fi.

In three dimensions, the vector (x, x') can be replaced by the complex vector (u,u')=(x+iy, x'+iy') (where i denotes $\sqrt{-1}$). Furthermore, magnetic lenses also rotate the electron ray vector by an angle θ. This rotation depends on the lens excitation NI (N=number of coil turns; I=coil current) and the relativistic corrected energy U* via:

$\vartheta = \mu_0 \sqrt{e/8m} \; NI/\sqrt{U^*} = 0.186 \; NI / \sqrt{U^*}$ and can be included in the matrix formalism [1] by multiplying the lens matrix by a complex factor $\exp^{i\theta}$. The e and m, respectively, denote the electron charge and mass, and $\mu_0$ is the permeability of vacuum.

With a plurality of lenses positioned in series-thus forming a compound lens/imaging system-it can be convenient to describe the lens action by a matrix that operates at the geometrical center of the lens. Starting from Z0, a ray first moves to the Zpo plane, then the lens action described by equation [1] occurs, after which the ray moves back from Zpi to the geometrical center of the lens-which can be described by:

$$\begin{pmatrix} u_{out} \\ u'_{out} \end{pmatrix} = e^{i\vartheta} \cdot \begin{pmatrix} 1 & Z_0 - Z_{pi} \\ 0 & 1 \end{pmatrix} \cdot \begin{pmatrix} 1 & 0 \\ -\frac{1}{fi} & 1 \end{pmatrix} \cdot \begin{pmatrix} 1 & Z_{po} - Z_0 \\ 0 & 1 \end{pmatrix} \cdot \begin{pmatrix} u_{i\,n} \\ u'_{i\,n} \end{pmatrix} = L \cdot \begin{pmatrix} u_{i\,n} \\ u'_{i\,n} \end{pmatrix} \quad [2]$$

Furthermore, use is made of a drift matrix:

$\Delta = \begin{pmatrix} 1 & d \\ 0 & 1 \end{pmatrix}$ which does not change the angle u' of a ray vector, but changes u to u+d·u' (drift over distance d). For a system of n lenses, one can now write:

$$\begin{pmatrix} u\_image \\ u'\_image \end{pmatrix} = \Delta\big(L\_n -> image\big) \cdot L\_n \cdot \ldots \cdot \Delta\big(L\_1 -> L\_2\big) \cdot L\_1 \cdot \Delta\big(object -> L\_1\big) \cdot \begin{pmatrix} u\_object \\ u'\_object \end{pmatrix} \quad [3]$$

in which the Δ terms are drift matrices (see above) and the L terms are lens matrices (see equation [2]). By inverting the total system matrix, a calculation can be performed from image plane to object plane. Calculations for focusing the lens series can be more accurate in the backward direction because the magnification M of imaging/projection systems is typically much larger than 1, and therefore the depth of focus is much smaller at the object plane than at the image plane.

The optical properties of a given lens system can be calculated by solving equation [3]. In some examples, software can be used that employs a root-finding algorithm (such as a Newton-Raphson algorithm). Similarly, software can be used to calculate and determine the cardinal planes Zpi, Zpo, Zfi, Zfo in the discussion above.

Algorithms may be, for example, embodied as software or firmware instructions carried out by a controller, such as a digital computing device. For instance, any of the disclosed calculations for the system of lenses can be performed by a computer or other computing hardware (e.g., an ASIC, FPGA, CPLD, etc.) that is part of a control system (e.g., control system 210 of FIG. 2). The control system can be connected to or otherwise in communication with the imaging system (e.g., the lenses) and be programmed or configured to receive imaging data from the sensing device(s) or user control inputs and perform the desired computations for the operating parameters of the lens system or look-up table accesses (e.g., any of the lens parameter variation techniques disclosed herein). The controller can be a computer system comprising one or more processors (processing devices) and tangible, non-transitory computer-readable media (e.g., one or more optical media discs, volatile memory devices (such as DRAM or SRAM), or nonvolatile memory or storage devices (such as hard drives, NVRAM, and solid state drives (e.g., Flash drives)). The one or more processors can execute computer-executable instructions stored on one or more of the tangible, non-transitory computer-readable media, and thereby perform any of the disclosed techniques. For instance, software for performing any of the disclosed embodiments can be stored on the one or more volatile, non-transitory computer-readable media as computer-executable instructions, which when executed by the one or more processors, cause the one or more processors to perform any of the disclosed techniques for computation of the operating parameters of the lens system. The results of the computations can be stored (e.g., in a suitable data structure or look-up table) in the one or more tangible, non-transitory computer-readable storage media and/or can also be output to the user, for example, by displaying, on a display device, with a graphical user interface.

In the preceding description, various embodiments have been described. For purposes of explanation, specific configurations and details have been set forth in order to provide a thorough understanding of the embodiments. However, it will also be apparent to one skilled in the art that the embodiments may be practiced without the specific details. Furthermore, well-known features may have been omitted or simplified in order not to obscure the embodiment being described. While example embodiments described herein center on electron microscopy systems, and scanning transmission electron microscopy systems in particular, these are meant as non-limiting, illustrative embodiments. Embodiments of the present disclosure are not limited to such embodiments, but rather are intended to address analytical instruments systems for which a wide array of material samples can be analyzed to determine chemical, biological, physical, structural, or other properties, among other aspects, including but not limited to chemical structure, trace element composition, or the like. As such, embodiments of the present disclosure include charged particle instruments more broadly, including focused ion beam systems, scanning electron microscope systems, electron beam microanalysis systems, or the like.

Some embodiments of the present disclosure include a system including one or more data processors and/or logic circuits. In some embodiments, the system includes a non-transitory computer readable storage medium containing instructions which, when executed on the one or more data processors and/or logic circuits, cause the one or more data processors and/or logic circuits to perform part or all of one or more methods and/or part or all of one or more processes and workflows disclosed herein. Some embodiments of the present disclosure include a computer-program product tangibly embodied in non-transitory machine-readable storage media, including instructions configured to cause one or more data processors and/or logic circuits to perform part or all of one or more methods and/or part or all of one or more processes disclosed herein.

The terms and expressions which have been employed are used as terms of description and not of limitation, and there is no intention in the use of such terms and expressions of excluding any equivalents of the features shown and described or portions thereof, but it is recognized that various modifications are possible within the scope of the claims. Thus, it should be understood that although the present disclosure includes specific embodiments and optional features, modification and variation of the concepts herein disclosed may be resorted to by those skilled in the art, and that such modifications and variations are considered to be within the scope of the appended claims.

Where terms are used without explicit definition, it is understood that the ordinary meaning of the word is intended, unless a term carries a special and/or specific meaning in the field of charged particle microscopy systems or other relevant fields. The terms "about" or "substantially" are used to indicate a deviation from the stated property within which the deviation has little to no influence of the corresponding function, property, or attribute of the structure being described. In an illustrated example, where a dimensional parameter is described as "substantially equal" to another dimensional parameter, the term "substantially" is intended to reflect that the two parameters being compared can be unequal within a tolerable limit, such as a fabrication tolerance or a confidence interval inherent to the operation of the system. Similarly, where a geometric parameter, such as an alignment or angular orientation, is described as "about" normal, "substantially" normal, or "substantially" parallel, the terms "about" or "substantially" are intended to reflect that the alignment or angular orientation can be different from the exact stated condition (e.g., not exactly normal) within a tolerable limit. For numerical values, such as diameters, lengths, widths, or the like, the term "about" can be understood to describe a deviation from the stated value of up to $\pm 10\%$. For example, a dimension of "about 10 mm" can describe a dimension from 9 mm to 11 mm.

The description provides exemplary embodiments, and is not intended to limit the scope, applicability or configuration of the disclosure. Rather, the ensuing description of the exemplary embodiments will provide those skilled in the art with an enabling description for implementing various embodiments. It is understood that various changes may be made in the function and arrangement of elements without departing from the spirit and scope as set forth in the appended claims. Specific details are given in the description to provide a thorough understanding of the embodiments. However, it will be understood that the embodiments may be practiced without these specific details. For example, specific system components, systems, processes, and other elements of the present disclosure may be shown in schematic diagram form or omitted from illustrations in order not to obscure the embodiments in unnecessary detail. In other instances, well-known circuits, processes, components, structures, and/or techniques may be shown without unnecessary detail.

Aspects of the invention may be defined by the following numbered clauses.

Clause 1. A method for interrogating a sample with a charged particle beam system, the method comprising: modifying an accelerating voltage of a source of the charged particle beam system from a first energy to a second energy, the first energy and the second energy separated by an energy difference; modifying one or more optical elements of the charged particle beam system, in accordance with a calibration for the second energy; generating a set of operating conditions for a projection optics system of the charged particle beam system, the set of operating conditions being based at least in part on operating the source at about the second energy; modifying one or more elements of the projection optics system in at least partial accordance with the set of operating conditions; modifying a condenser lens of the charged particle beam system in accordance with focusing a beam of charged particles onto a sample position, the beam of charged particles having an energy about the second energy; and modifying the accelerating voltage from the second energy to the first energy.

Clause 2. The method of clause 1, further comprising: modifying one or more optical elements of an electron energy loss (EELS) spectrometer of the charged particle beam system in accordance with focusing the beam of charged particles onto a detector of the EELS spectrometer, the beam of charged particles having an energy about the second energy.

Clause 3. The method of clause 2, wherein the beam of charged particles is a first beam, the method further comprising: generating a second beam of charged particles, the second beam of charged particles having an energy about the first energy; directing the first beam of charged particles through the sample position; and generating detector data using the detector of the EELS spectrometer.

Clause 4. The method of clause 1, further comprising: modifying one or more optical elements of the charged particle beam system in accordance with focusing the beam of charged particles onto the sample position, the focusing corresponding to a fine focus at a spatial resolution of about 0.1 nm or less.

Clause 5. The method of clause 1, wherein the second energy is from about 90% to about 98.5% of the first energy.

Clause 6. The method of clause 5, wherein the first energy is about 300 keV and the second energy is from about 270 keV to about 295 keV.

Clause 7. The method of clause 1, wherein the first energy and the second energy are related by the expression $A = |(\Delta E+E2-E1)/E2|$, where $\Delta E$ is the energy loss associated with an edge (keV), E1 is the first energy (keV), and E2 is the second energy (keV); and the expression A is from about 1% to about 10%.

Clause 8. The method of clause 1, wherein generating the set of operating conditions comprises determining a solution for a first order approximation of the projection optics assembly, the solution configuring the beam of charged particles to define a final cross over (FXO) between the projection optics assembly and a detector plane that substantially satisfies one or more boundary conditions of the charged particle beam system, wherein the boundary conditions include a magnification at a detector of the charged particle beam system.

Clause 9. The method of clause 8, wherein determining the solution comprises referencing a dataset of operating conditions for the charged particle beam system using the second energy and an input parameter, the dataset describing multiple sets of operating conditions for the projection optics assembly associated with one or more accelerating voltages.

Clause 10. The method of clause 8, wherein determining the solution comprises solving a mathematical expression describing the first order approximation of the projection optics assembly.

Clause 11. One or more machine readable storage media, storing instructions that, when executed by a machine, cause the machine to perform operations comprising: modifying an accelerating voltage of a source of a charged particle beam system from a first energy to a second energy, the first energy and the second energy separated by an energy difference; modifying one or more optical elements of the charged particle beam system, in accordance with a calibration for the second energy; generating a set of operating conditions for a projection optics system of the charged particle beam system, the set of operating conditions being based at least in part on operating the source at about the second energy; modifying one or more elements of the projection optics system in at least partial accordance with the set of operating conditions; modifying a condenser lens of the charged particle beam system in accordance with focusing a beam of charged particles onto a sample position, the beam of charged particles having an energy about the second energy; and modifying the accelerating voltage from the second energy to the first energy.

Clause 12. The media of clause 11, the operations further comprising: modifying one or more optical elements of an electron energy loss (EELS) spectrometer of the charged particle beam system in accordance with focusing the beam of charged particles onto a detector of the EELS spectrometer, the beam of charged particles having an energy about the second energy. Clause 13. The media of clause 12, wherein the beam of charged particles is a first beam, the operations further comprising: generating a second beam of charged particles, the second beam of charged particles having an energy about the first energy; directing the second beam of charged particles through the sample position; and generating detector data using the detector of the EELS spectrometer.

Clause 14. The media of clause 1, the operations further comprising: modifying one or more optical elements of the charged particle beam system in accordance with focusing the beam of charged particles onto the sample position, the focusing corresponding to a fine focus at a spatial resolution of about 0.1 nm or less.

Clause 15. The media of clause 11, wherein the second energy is from about 90% to about 98.5% of the first energy.

Clause 16. The media of clause 11, wherein generating the set of operating conditions comprises determining a solution for a first order approximation of the projection optics assembly, the solution configuring the beam of charged particles to define a final cross over (FXO) between the projection optics assembly and a detector plane that substantially satisfies one or more boundary conditions of the charged particle beam system, wherein the boundary conditions include a magnification at a detector of the charged particle beam system.

Clause 17. The method of clause 16, wherein determining the solution comprises referencing a dataset of operating conditions for the charged particle beam system using the second energy and an input parameter, the dataset describing multiple sets of operating conditions for the projection optics assembly associated with one or more accelerating voltages.

Clause 18. The method of clause 16, wherein determining the solution comprises solving a mathematical expression describing the first order approximation of the projection optics assembly.

Clause 19. A charged particle beam system, comprising: a charged particle source; a charged particle optical column coupled with the source, comprising: an objective section, defining a sample position; and a projection optics system; a detector section, coupled with the column; control circuitry, operably coupled with the source, the column, and the detector section; and one or more machine readable storage media, operably coupled with the control circuitry, storing instructions that, when executed by a machine, cause the machine to perform one or more operations comprising: modifying an accelerating voltage of a source of the charged particle beam system from a first energy to a second energy, the first energy and the second energy separated by an energy difference; modifying an optical element of the charged particle beam system, such that the optical element is calibrated for the second energy; generating a set of operating conditions for the projection optics system, the set of operating conditions being based at least in part on operating the charged particle source at about the second energy; modifying one or more elements of the projection optics system in at least partial accordance with the set of operating conditions; modifying a condenser lens of the charged particle beam system in accordance with focusing a beam of charged particles onto the sample position, the beam of charged particles having an energy about the second energy; and modifying the accelerating voltage from the second energy to the first energy.

Clause 20. The system of clause 19, the detector section comprising an electron energy loss spectrometer coupled with the column and oriented to receive the beam of charged particles via the projection optics system, the operations further comprising: modifying one or more optical elements of an electron energy loss (EELS) spectrometer of the charged particle beam system in accordance with focusing the beam of charged particles onto a detector of the EELS spectrometer, the beam of charged particles having an energy about the second energy; generating a second beam of charged particles, the second beam of charged particles having an energy about the first energy; directing the second beam of charged particles through the sample position; and generating detector data using the detector of the EELS spectrometer.

## Claims

1. A method for interrogating a sample with a charged particle beam system, the method comprising:

   modifying an accelerating voltage of a source of the charged particle beam system from a first energy to a second energy, the first energy and the second energy separated by an energy difference;
   modifying one or more optical elements of the charged particle beam system, in accordance with a calibration for the second energy;
   generating a set of operating conditions for a projection optics system of the charged particle beam system, the set of operating conditions being based at least in part on operating the source at about the second energy;

modifying one or more elements of the projection optics system in at least partial accordance with the set of operating conditions;

modifying a condenser lens of the charged particle beam system in accordance with focusing a beam of charged particles onto a sample position, the beam of charged particles having an energy about the second energy; and

modifying the accelerating voltage from the second energy to the first energy.

2. The method of claim 1, further comprising:
modifying one or more optical elements of an electron energy loss (EELS) spectrometer of the charged particle beam system in accordance with focusing the beam of charged particles onto a detector of the EELS spectrometer, the beam of charged particles having an energy about the second energy.

3. The method of claim 2, wherein the beam of charged particles is a first beam, the method further comprising:

generating a second beam of charged particles, the second beam of charged particles having an energy about the first energy;

directing the first beam of charged particles through the sample position; and

generating detector data using the detector of the EELS spectrometer.

4. The method of any of claims 1-3, further comprising:
modifying one or more optical elements of the charged particle beam system in accordance with focusing the beam of charged particles onto the sample position, the focusing corresponding to a fine focus at a spatial resolution of about 0.1 nm or less.

5. The method of any of claims 1-4, wherein the second energy is from about 90% to about 98.5% of the first energy.

6. The method of any of claims 1-5, wherein the first energy is about 300 keV and the second energy is from about 270 keV to about 295 keV.

7. The method of any of claims 1-6, wherein the first energy and the second energy are related by the expression $A = |(\Delta E+E2-E1)/E2|$, where $\Delta E$ is the energy loss associated with an edge (keV), E1 is the first energy (keV), and E2 is the second energy (keV); and the expression A is from about 1% to about 10%.

8. The method of any of claims 1-7, wherein generating the set of operating conditions comprises determining a solution for a first order approximation of the projection optics assembly, the solution configuring the beam of charged particles to define a final cross over (FXO) between the projection optics assembly and a detector plane that substantially satisfies one or more boundary conditions of the charged particle beam system, wherein the boundary conditions include a magnification at a detector of the charged particle beam system.

9. The method of claim 8, wherein determining the solution comprises referencing a dataset of operating conditions for the charged particle beam system using the second energy and an input parameter, the dataset describing multiple sets of operating conditions for the projection optics assembly associated with one or more accelerating voltages.

10. The method of claim 8, wherein determining the solution comprises solving a mathematical expression describing the first order approximation of the projection optics assembly.

11. A computer program product comprising instructions which, when the program is executed by a computer, cause the computer to carry out the steps of the method of any of claims 1 to 10.

12. A charged particle beam system, comprising:

a charged particle source;
a charged particle optical column coupled with the source, comprising:

an objective section, defining a sample position; and
a projection optics system;

a detector section, coupled with the column;
control circuitry, operably coupled with the source, the column, and the detector section; and

one or more machine readable storage media, operably coupled with the control circuitry, storing instructions that, when executed by a machine, cause the machine to perform one or more operations comprising:

modifying an accelerating voltage of a source of the charged particle beam system from a first energy to a second energy, the first energy and the second energy separated by an energy difference;

modifying an optical element of the charged particle beam system, such that the optical element is calibrated for the second energy;

generating a set of operating conditions for the projection optics system, the set of operating conditions being based at least in part on operating the charged particle source at about the second energy;

modifying one or more elements of the projection optics system in at least partial accordance with the set of operating conditions;

modifying a condenser lens of the charged particle beam system in accordance with focusing a beam of charged particles onto the sample position, the beam of charged particles having an energy about the second energy; and

modifying the accelerating voltage from the second energy to the first energy.

13. The system of claim 12, the detector section comprising an electron energy loss spectrometer coupled with the column and oriented to receive the beam of charged particles via the projection optics system, the operations further comprising:

modifying one or more optical elements of an electron energy loss (EELS) spectrometer of the charged particle beam system in accordance with focusing the beam of charged particles onto a detector of the EELS spectrometer, the beam of charged particles having an energy about the second energy;

generating a second beam of charged particles, the second beam of charged particles having an energy about the first energy;

directing the second beam of charged particles through the sample position; and

generating detector data using the detector of the EELS spectrometer.

14. The system of any of claims 12-13, wherein the second energy is from about 90% to about 98.5% of the first energy; and/or wherein the first energy is about 300 keV and the second energy is from about 270 keV to about 295 keV.

15. The system of any of claims 12-14, wherein the first energy and the second energy are related by the expression $A = |(\Delta E + E2 - E1)/E2|$, where $\Delta E$ is the energy loss associated with an edge (keV), E1 is the first energy (keV), and E2 is the second energy (keV); and the expression A is from about 1% to about 10%.

ELECTRON SOURCE SECTION 101

103

100

CONDENSER LENSES

CONDENSER APERTURE

SAMPLE SECTION 107

OBJ. COND. LENS
OBJ. APERTURE
OBJ. IMAGING LENS

108

MINI COND. LENS

TEM COLUMN 105

109

PROJECTOR OPTICS 111

SELECTED AREA APERTURE
DIFF. LENS
INTERM. LENS
PROJECTOR LENSES

DETECTOR SECTION 110

EELS SPECTROMETER 115

FIG. 1

MICROSCOPE
201

205

215

200

220
220
220

$E_1$

225
223

221

215

227

230
230
230
230

$E_2$

225

$E_2$

235

$E_2$

255

250
260

SPECTROMETER 115

240    240    240    245

211

CONTROL 210
SYSTEM

FIG. 2

300

305

┌─────────────────────────────────────────────┐
│              REDUCE HIGH TENSION              │
└─────────────────────────────────────────────┘
                       │
                       ▼
310

┌─────────────────────────────────────────────┐
│         (RE)CALIBRATE OPTICAL ELEMENT(S)      │
└─────────────────────────────────────────────┘
                       │
                       ▼
315

┌─────────────────────────────────────────────┐
│            MODIFY PROJECTION OPTICS           │
└─────────────────────────────────────────────┘
                       │
                       ▼
320

┌─────────────────────────────────────────────┐
│            FOCUS CONDENSER OPTIC(S)           │
└─────────────────────────────────────────────┘
                       │
                       ▼
325

┌─────────────────────────────────────────────┐
│           FOCUS SPECTROMETER OPTIC(S)         │
└─────────────────────────────────────────────┘
                       │
                       ▼
330

┌─────────────────────────────────────────────┐
│               RAISE HIGH TENSION              │
└─────────────────────────────────────────────┘
                       │
                       ▼
335

┌─────────────────────────────────────────────┐
│             GENERATE DETECTOR DATA            │
└─────────────────────────────────────────────┘

**FIG. 3**

FIG. 4A   FIG. 4B

400   405   410   415   420   421   425   430   435   440   445   450   455

B

$M_{OBJ}$   $M_{XO}$   $M_{PROJ}$

CONDENSER SYSTEM

BEAM LIMITING APERTURE

PROBE-FORMING OBJ. LENS

SPECIMEN OBJ. LENS

BACK FOCAL PLANE (BFP)

FIRST IMAGE PLANE (FIP)

PROJECTOR OPTICS

FINAL CROSS-OVER (FXO)

SCREEN/DETECTOR

FIG. 4C

FIG. 4D

FIG. 4E

**FIG. 5A**

**FIG. 5B**

FIG. 6

Europäisches
Patentamt

European
Patent Office

Office européen
des brevets

# EUROPEAN SEARCH REPORT

**Application Number**

EP 25 20 0745

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CRAVEN ALAN J ET AL: "Getting the most out of a post-column EELS spectrometer on a TEM/STEM by optimising the optical coupling", ULTRAMICROSCOPY, vol. 180, 1 April 2017 (2017-04-01), pages 66-80, XP085062215, ISSN: 0304-3991, DOI: 10.1016/J.ULTRAMIC.2017.03.017 * the whole document * | 1-15 | INV. H01J37/26 |
| A | US 2004/188608 A1 (KANEYAMA TOSHIKATSU [JP]) 30 September 2004 (2004-09-30) * paragraphs [0046] - [0070]; figures * | 1-15 | |

**TECHNICAL FIELDS SEARCHED (IPC)**

H01J

The present search report has been drawn up for all claims

| Place of search | Date of completion of the search | Examiner |
|---|---|---|
| Munich | 22 January 2026 | Schmidt-Kärst, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 20 0745

This annex lists the patent family members relating to the patent documents cited in the above-mentioned European search report.
The members are as contained in the European Patent Office EDP file on
The European Patent Office is in no way liable for these particulars which are merely given for the purpose of information.

22-01-2026

| Patent document cited in search report | Publication date | Patent family member(s) | | Publication date |
|---|---|---|---|---|
| US 2004188608 A1 | 30-09-2004 | EP | 1441382 A2 | 28-07-2004 |
| | | JP | 3979945 B2 | 19-09-2007 |
| | | JP | 2004227942 A | 12-08-2004 |
| | | US | 2004188608 A1 | 30-09-2004 |

EPO FORM P0459

For more details about this annex : see Official Journal of the European Patent Office, No. 12/82